# EUROPÄISCHE PATENTANMELDUNG

(11) **EP 0 818 564 A2**
(43) Veröffentlichungstag der Anmeldung: **14.01.1998**
(21) Anmeldenummer: 97106414.2
(22) Anmeldetag: 18.04.1997
(51) Int. Cl.: C30B 15/00, B66F 9/00

(54) **Vorrichtung zum Heben, Schwenken und Drehen eines schweren Anlagenteils**

(30) Priorität: 13.07.1996 DE 19628316
(71) Anmelder: Leybold Systems GmbH, D-63450 Hanau am Main (DE)
(72) Erfinder: Scholler, Johann, 64859 Eppertshausen (DE)

(57) **Zusammenfassung**

Bei einer Vorrichtung zum Heben, Schwenken und Drehen des Deckels (5) eines Vakuumkessels (14) einer Kristallziehanlage mit einem von einem ortsfesten Teil (15) der Anlage gehaltenen, sich lotrecht erstreckenden Bolzen (26) ist zu diesem Zweck eine den Bolzen (26) umschließende, auf diesem drehbare Hülse (24) mit fest an der Hülse (24) angeordneten, sich horizontal erstreckenden Nasen (34,34') vorgesehen, mit von den Nasen (34,34') gehaltenen, sich quer zu diesen erstreckenden Bolzen (36,36') und einem um diese schwenkbaren Hülsenteil (28) eines Gehäuses (35), wobei im Gehäuse (35) ein sich parallel zu seinem Hülsenteil (28) erstreckender und von diesem beabstandeter Gewindezapfen (37) mit Handhebel (21) gelagert ist, der mit einer Schraubenmutter (38) zusammenwirkt, die ihrerseits an der Hülse (24) gehalten ist, wobei das Hülsenteil (28) einen Zapfen (27) umschließt, der mit dem Vorrichtungsteil oder Deckel 85) fest verbunden ist.

## Beschreibung

Die Erfindung betrifft eine Vorrichtung zum Heben, Schwenken und Drehen eines schweren Anlagenteils, insbesondere des Deckels eines Vakuumkessels einer Kristallziehanlage mit einem von einem ortsfesten Teil der Anlage gehaltenen, sich lotrecht erstrekkenden Arm oder Bolzen.

Vorrichtungen zum Ziehen von Kristallen umfassen üblicherweise ein Gerüst oder Tragwerk aus Metallrohren oder Metallprofilen, an das die für den Ziehprozeß notwendigen Aggregate, wie z. B. die Vakuumkammer, die Schleuse, die Schleusenkammer, das Ziehelement, angebracht sind.

So ist eine Vorrichtung zum tiegellosen Zonenschmelzen bekannt (DE 1.290.117), bestehend aus zwei vertikalen Führungssäulen, die auf einem Podest befestigt und oben durch eine Querstrebe miteinander verbunden sind, welche zwei relativ zueinander und relativ zu einer ortsfesten Heizvorrichtung verschiebbare Arme mit den Stabhalterungen tragen, wobei die Arme mit einem Differentialgetriebe gekoppelt sind, und die beiden Führungssäulen mit zwei mittels Schraubgewinden oben an der Querstrebe und unten am Podest befestigten, schräg zu den Führungssäulen und zueinander verlaufenden Stützorganen ausgerüstet sind, wobei die Führungssäulen über je ein gleich hohes Biegegelenk in Gestalt eines nach der Seite der Stützorgane offenen Schlitzes mit dem Podest verbunden sind.

Diese bekannte Vorrichtung eignet sich nicht für Anlagen zum Ziehen sehr großer Kristalle, da die einzelnen Aggregate einer solchen großen Vorrichtung zu voluminös und zu schwer und für den Einbau in das bekannte Tragwerk zu wenig zugänglich für das Bedienpersonal sind.

Schließlich ist in einer älteren Anmeldung (DE 195 38 857.7) bereits eine Vorrichtung zum Ziehen von Einkristallen aus einer in einem Tiegel befindlichen Schmelze unter Vakuum oder unter Schutzgas bei vermindertem Druck vorgeschlagen worden, bei der der Tiegel in einer auf einem Grundgestell abgestützten Vakuumkammer auf einem Tiegeltragbolzen angeordnet und durch die Wärmestrahlung eines Heizelements erhitzbar ist, und wobei ein Ziehelement oberhalb der Schmelze vorgesehen ist, mit dem der Kristall von der Schmelzenoberfläche aus nach oben zu in eine gegenüber dem Grundgestell seitlich schwenkbare Schleusenkammer herausziehbar ist sowie mit einer Entkopplungsvorrichtung, die zwischen dem Kristall und dem Ziehelement vorgesehen ist und die Trennung des Kristalls von dem Ziehelement gestattet, wobei das Grundgestell aus einer von Stützen getragenen Plattform gebildet ist, wobei auf der etwa rechteckigen, die Vakuumkammer haltenden Plattform an drei ihrer vier Ecken jeweils ein weiteres Bein abgestützt ist und diese drei sich lotrecht erstreckenden Beine gleicher Länge zusammen an ihren oberen Enden von einem ein rechteckiges Dreieck bildenden, sich horizontal erstreckenden Rahmen gehalten sind, wobei die von diesem Rahmen auf die Plattform projizierte Fläche etwa die eine Hälfte der Plattformfläche umschreibt, wobei an mindestens einem der Beine ein Galgen oder Schwenkarm gelagert ist, an dem die Schleusenkammer befestigt ist, die sich parallel der Beine bis etwa zum Dekkel der Vakuumkammer erstreckt.

Aufgabe der vorliegenden Erfindung ist es, eine Vorrichtung des eingangs genannten Typs zu schaffen, bei der der zwischen Schleusenkammer und Tiegel zum Aufschmelzen des Siliziums angeordnete, den Tiegel nach oben zu abschließende Deckel von der Vakuumkammer abgehoben, danach verschwenkt wird und schließlich zum Zwecke der Reinigung gedreht werden kann. Die Vorrichtung soll preiswert herstellbar sein, ein Minimum an Platz bendötigen und insofern einstellbar sein, als der Deckel von der Vorrichtung in eine genau definierte Endposition verfahrbar sein soll.

Nach der vorliegenden Erfindung wird diese Aufgabe gelöst durch eine den Bolzen umschließende, auf diesem drehbaren Hülse und fest an der Hülse angeordneten, sich horizontal von dieser aus erstrekkenden Nasen, mit einem von den Nasen gehaltenen, sich quer zu diesen erstreckenden Bolzen und einem um diesen schwenkbaren Hülsenteil eines Gehäuses, wobei im Gehäuse ein sich parallel zu seinem Hülsenteil erstreckender und von diesem beabstandeter Gewindezapfen mit Handhebel gelagert ist, der mit einer Schraubenmutter zusammenwirkt, die ihrerseits an der Hülse gehalten ist, und wobei das Hülsenteil einen Zapfen umschließt, der mit dem Vorrichtungsteil oder Deckel fest verbunden ist.

Weitere Einzelheiten und Merkmale sind in den Patentansprüchen näher beschrieben und gekennzeichnet.

Die Erfindung läßt die verschiedensten Ausführungsmöglichkeiten zu, eine davon ist in den anhängenden Zeichnungen rein schematisch dargestellt; und zwar zeigen:
- Figur 1: eine Kristallziehanlage in perspektivischer Darstellung,
- Figur 2: die Vorrichtung zum Heben, Schwenken und Drehen des Deckels des Vakuumkessels der Kristallziehvorrichtung nach Figur 1, teilweise im Schnitt, in der Seitenansicht und in vergrößerter Darstellung und
- Figur 3: das Gehäuseteil der Vorrichtung nach Figur 2 in der Frontansicht.

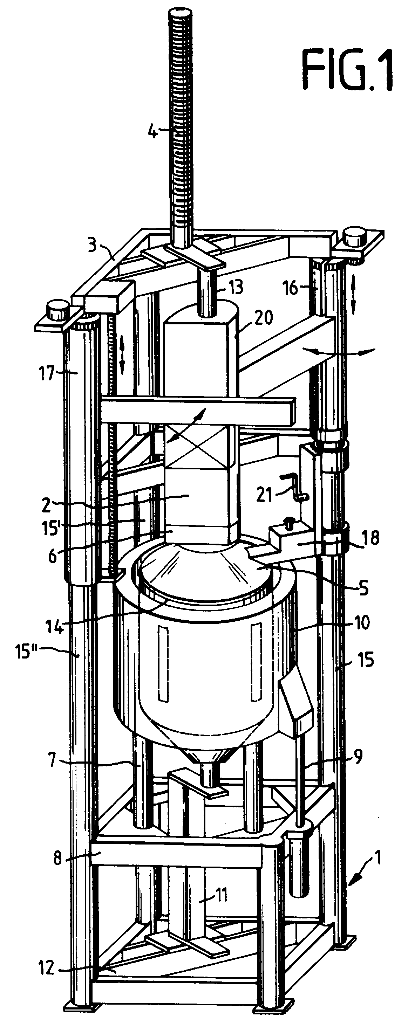

Bei der Anordnung gemäß Figur 1 ist auf ein vierbeiniges, als Gitterrohrrahmen ausgeführtes Grundgestell 1, von dem aus drei Säulen über die Schleuse 2 nach oben zu hinaufreichen, ein dreiekkiger Abschlußrahmen 3 aufgeschraubt. Auf diesen Rahmen ist der Ziehvorschub 4 (Stangenvorschub oder Seilvorschub) aufgesetzt. Der Deckel 5 des Vakuumkessels sowie das Schleusenventil 6 und die Schleuse 2 sind mittels Stützen 7 auf Querverbindungen 8 des Grundgestells 1 gelagert. Ebenfalls stützt sich der Magnet 10 oder dessen Hebe- und Senkeinrichtung 9 auf Querverbindungen 8 ab. Die Querverbindungen 8 sind dergestalt ausgeführt und angeordnet, daß der Magnet 10 zu Wartungs- oder Reinigungszwecken der Anlage abgesenkt werden kann. Der Tiegelvorschub 11 stützt sich auf den unteren Querverbindungen 12 des Grundgestells 1 ab. Der Deckel 5, das Schleusenventil 6 und die Schleuse 2 sind mittels Balg 13 von den Vorschüben 4 und 11 schwingungstechnisch und lagemäßig entkoppelt, so daß kein nachteiliger Einfluß durch auftretende Schwingungen oder Lageveränderung der Kesselteile 5, 6, 2 auf den Ziehvorgang auftritt.

In die nach oben verlängerten Säulen 15, 15', 15'' des Grundgestells 1 können nun unterschiedliche Funktionselemente integriert werden, z. B. eine speziell ausgeführte Handlingseinrichtung 16 für die Schleuse 2 und das Schleusenventil 6 oder für den Deckel 5 sowie für den Trennmechanismus für den Kristallhals, für Aufnahmeeinrichtungen für Kristalle, Handlingseinrichtungen 17 für Kesselteile und/oder Hot-Zoneteile innerhalb des Kessels 14. Ebenfalls integrierbar sind Zusatzeinrichtungen wie Chargiereinrichtung und Dotiereinrichtung.

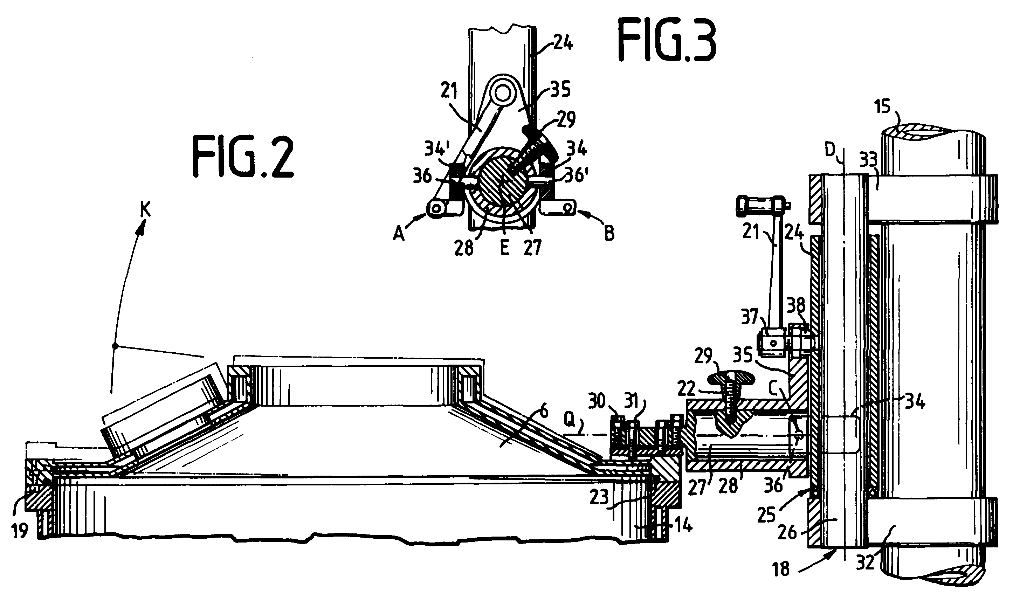

Die in Figur 2 dargestellte Vorrichtung 18 zum Schwenken und Drehen des Deckels 5 ist mit einem feststehenden Teil der Kristallziehvorrichtung, nämlich der Säule 15 verbunden. Während des Ziehprozesses ist der Deckel 5 zwischen den darüber- und darunterliegenden Bauteilen 6 und 14 eingespannt. Der Zentrierzapfen 19 zur exakten Positionierung des Deckels 5 zur Anlagenmitte befindet sich gegenüber der Hub-, Schwenk- und Dreheinrichtung 18.

Nachdem die darüberliegenden Teile, nämlich das Schleusenventil 6 und die Schleusenkammer 20 abgehoben wurden, kann mit Hilfe des Hebels 21 (oder alternativ mit einem Handrad) der von der Einraststelle A zur Einraststelle B bewegt wird, der Dekkel 5 um den Drehpunkt C gekippt werden. Die Drehung des Hebels 21 bewirkt auf dem Gewindebolzen 37 einen Axialweg, da sich der Gewindebolzen 37 in die ortsfeste Schraubenmutter 38 hinein- bzw. herausschraubt.

Durch die leichte Schräglage des Deckels 5 ist der Dichtring 23 am gesamten Umfang frei und der Zentrierzapfen 19 genügend weit aus der Zentrierhalterung herausgefahren worden.

Der Deckel 5 kann jetzt um die Drehachse D, bestehend aus der die Säule 15 umgreifenden Hülse 24 mit Gleitlagern, einem Axiallager (Stützlager) 25 und dem Bolzen 26, aus dem Arbeitsbereich geschwenkt werden.

Um die Reinigungsarbeiten zu erleichtern, besteht jetzt noch die Möglichkeit, durch Lösen der Flügelmutter 27 den Deckel 5 um seine Querachse Q zu drehen. Dies geschieht um den Drehpunkt E. Hier ist der Zapfen 27 im Hülsenteil 28 gelagert und vom Gewindebolzen 22, der in einer Kulisse im Hülsenteil 28 geführt ist, gegen ein Verschieben in der Querachse Q gesichert ist. Die Kulisse oder Radialnut (ca. 90° des Umfangs) in der Buchse 28, in der der Gewindebolzen 22 geführt ist, begrenzt zusätzlich den Drehwinkel. Die Flügelmutter 29 hat einen konischen Ansatz und die Radialnut an beiden Enden eine entsprechende Ansenkung, so daß beim Festziehen der Flügelmutter 29 die jeweilige Endposition fixiert wird. Die Flügelmutter 29 ist gegen vollständiges Herausdrehen gesichert.

Die Verbindung des Zapfens 27 zum Deckel 5 wird mit Ausrichtschrauben 30 und 31 hergestellt. Durch Langlöcher für die Schrauben 30 kann die Position des Deckels zum feststehenden Teil 14 der Anlage eingestellt werden.

### Bezugszeichenliste

- 1: Grundgestell
- 2: Schleuse
- 3: Abschlußrahmen
- 4: Ziehvorschub
- 5: Deckel
- 6: Schleusenventil
- 7: Stütze
- 8: Querverbindung
- 9: Hub- und Senkeinrichtung
- 10: Magnet
- 11: Tiegelvorschub
- 12: untere Querverbindung
- 13: Balg
- 14: Vakuumkessel
- 15,15',...: Säule
- 16: Handlingseinrichtung
- 17: Handlingseinrichtung
- 18: Handlingsvorrichtung
- 19: Zentrierzapfen
- 20: Schleusenkammer
- 21: Hebel
- 22: Gewindebolzen
- 23: Dichtung
- 24: Hülse
- 25: Axiallager
- 26: Bolzen
- 27: Zapfen
- 28: Hülsenteil
- 29: Griffmutter, Flügelmutter
- 30: Ausrichtschraube
- 31: Ausrichtschraube
- 32: Halter
- 33: Halter
- 34,34': Nase
- 35: Gehäuse
- 36,36': Bolzen
- 37: Gewindezapfen
- 38: Schraubenmutter

## Patentansprüche

1. Vorrichtung zum Heben, Schwenken und Drehen eines schweren Anlagenteils, insbesondere des Deckels (5) eines Vakuumkessels (14) einer Kristallziehanlage mit einem von einem ortsfesten Teil (15) der Anlage gehaltenen, sich lotrecht erstreckenden Bolzen (26) und einer den Bolzen (26) umschließenden, auf diesem drehbaren Hülse (24) und fest an der Hülse (24) angeordneten, sich horizontal erstrekkenden Nasen (34,34'), mit von den Nasen (34,34') gehaltenen, sich quer zu diesen erstreckenden Bolzen (36,36') und einem um diese schwenkbaren Hülsenteil (28) eines Gehäuses (35), wobei im Gehäuse (35) ein sich parallel zu seinem Hülsenteil (28) erstrekkender und von diesem beabstandeter Gewindezapfen (37) mit Handhebel (21) gelagert ist, der mit einer Schraubenmutter (38) zusammenwirkt, die ihrerseits an der Hülse (24) gehalten ist, wobei das Hülsenteil (28) einen Zapfen (27) umschließt, der mit dem Vorrichtungsteil oder Deckel 85) fest verbunden ist.

2. Vorrichtung nach Anspruch 1, **dadurch gekennzeichnet,** daß der vom Hülsenteil (28) des Gehäuses (35) umschlossene Zapfen (27) in seiner Lage in der Bohrung der Hülse (28) von einer Griffmutter oder Flügelmutter (29) arretierbar ist, wozu der Zapfen (27) mit einem sich radial erstreckenden Gewindebolzen (22) versehen ist, der in einem Schlitz oder Kulisse im Hülsenteil (28) geführt ist und von der Flügelmutter (29) gegenüber dem Hülsenteil (28) verklemmbar ist.

3. Vorrichtung nach den Ansprüchen 1 und 2, **dadurch gekennzeichnet,** daß der vom Hülsenteil (28) des Gehäuses (35) gehaltene Zapfen (27) mit der Randpartie des Deckels (5) verschraubt ist, wobei die Verschraubung (30,31) zum Zwecke der Justage eine geringe Kippbewegung K des Deckels (5) zur Zapfenlängsachse Q (Querachse) ermöglicht.

4. Vorrichtung nach den vorhergehenden Ansprüchen, **dadurch gekennzeichnet,** daß das auf den Nasen (34,34') kippbar gelagerte Gehäuse (35,28) einen sich etwa lotrecht erstreckenden Arm aufweist, an dessen freiem Ende ein Gewindezapfen (37) drehbar, jedoch unverschiebbar gelagert ist, der mit einer Schraubenmutter (38) zusammenwirkt, die an der Hülse (24) gehalten ist.
